# EUROPEAN PATENT SPECIFICATION

(11) **EP 1 193 771 B1**
(45) Date of publication and mention of the grant of the patent: **01.08.2012**
(21) Application number: 01307765.6
(22) Date of filing: 12.09.2001
(51) Int. Cl.: H01L 31/02, H01L 31/0304, H01L 31/173, H01L 31/18, H01L 33/00, H01S 5/30

(54) **Method for fabricating an optical semiconductor device**
Herstellungsverfahren eines optoelektronischen Halbleiter-Bauelements
Méthode de fabrication d'un dispositif semi-conducteur optique

(30) Priority: 27.09.2000 JP 2000293877
(43) Date of publication of application: 03.04.2002
(73) Proprietor: Eudyna Devices Inc., Nakakoma-Gun, Yamanashi (JP)
(72) Inventor: Watanabe, Takayuki, c/o Fujitsu Quantum Devices, Yamanashi 409-3883 (JP)
(74) Representative: Fenlon, Christine Lesley

(56) References cited:
- EP-A2- 0 617 471
- US-A- 5 260 230
- US-A- 5 822 349

## Description

The present invention relates to a method for fabricating an optical semiconductor device, more specifically a method for fabricating a semiconductor device including an optical integrated circuit, etc. for use in optical communication, photocoupling, etc.

In an optical semiconductor device formed of an InP-based material, horizontal light confinement depends on refractive index differences between the InGaAsP core and the InP buried layer, which guide light. A buried hetero (BH) structure is known to be used in semiconductor lasers as a structure for realizing such light confinement.

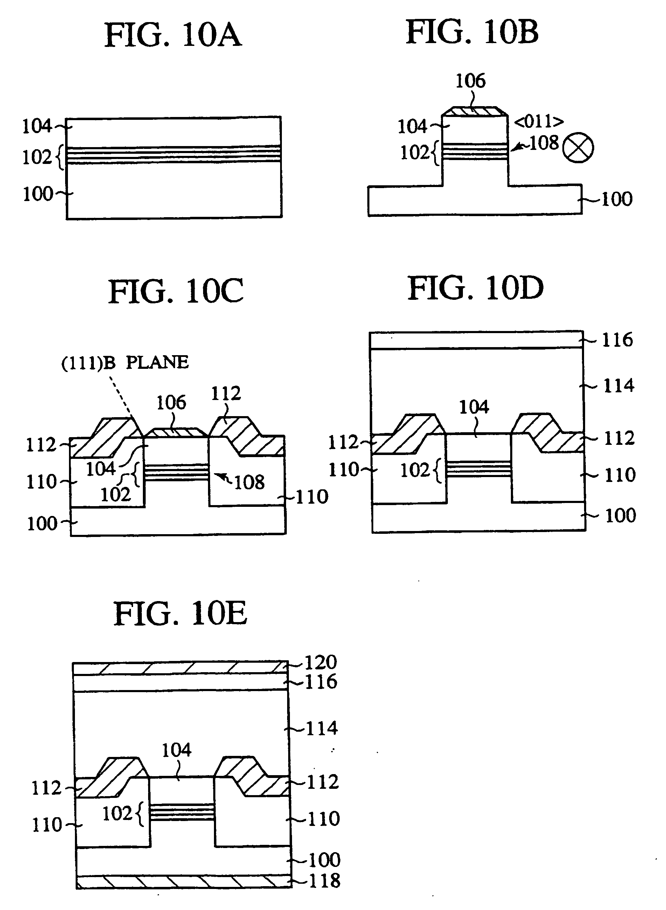

A method for fabricating a semiconductor laser with a BH structure will be explained with reference to FIGs. 10A-10E. FIGs. 10A-10E are sectional views of the semiconductor laser at stages in the method for fabricating the semiconductor laser.

As shown in FIG. 10A, an InGaAsP/InGaAsP multi-quantum well layer 102 and a p type InP clad layer 104 are formed sequentially on an n type InP substrate 100.

Then, as shown in FIG. 10B, an SiO₂ film 106 as an etching protection film is formed on the p type InP clad layer 104. An active layer mesa stripe 108 is then formed from the resulting structure by dry etching. The active layer mesa stripe 108 has <011> direction.

Subsequently, as shown in FIG. 10C, with the SiO₂ film 106 as a selective growth mask, a p type InP buried layer 110 and an n type InP buried layer 112 are sequentially crystal-grown on the InP substrate 100 around the active layer mesa stripe 108 by metal organic vapor phase epitaxy (MOVPE). In the crystal growth by MOVPE, a chlorine-based gas, such as CH₃Cl, is added so that, as shown in FIG. 10C, the crystal growth of the n type InP buried layer 112 stops at a (111) B plane as the growth stop face. Thus, the n type InP buried layer 112 can be formed, so as not to grow over the SiO₂ film 106.

Following the formation of the n type InP buried layer 112, the SiO₂ film 106 is removed by etching using HF, and a p type InP clad layer 114 and a p type InGaAs contact layer 116 are sequentially formed on the entire surface.

Finally, an n type electrode 118 is formed on the underside of the n type InP substrate 100, and a p type electrode 120 is formed on the p type InGaAs contact layer 116. Thus, the fabrication of the semiconductor laser of BH structure is completed.

Recently in the optical communication technique, optical integrated circuits having photodividers, photocouplers, photomodulators, photoswitches, etc. integrated have become key devices, for multi-wavelength communication and high-speed light modulation. Such optical integrated circuits are fabricated by the same method as the semiconductor laser of the BH structure described above.

However, in fabricating an optical integrated circuit of BH structure, the step of forming the buried layer after forming the active layer mesa stripe has problems although the step does not pose a problem in fabricating the semiconductor laser.

The resonator of the above-described semiconductor laser has <011> direction. As shown in FIG. 10C, the crystal growth of the n type InP buried layer 112 stops at the (111) B plane as the growth stop plane, so that the n type InP buried layer 112 can be formed, so as not to grow over the selective growth mask.

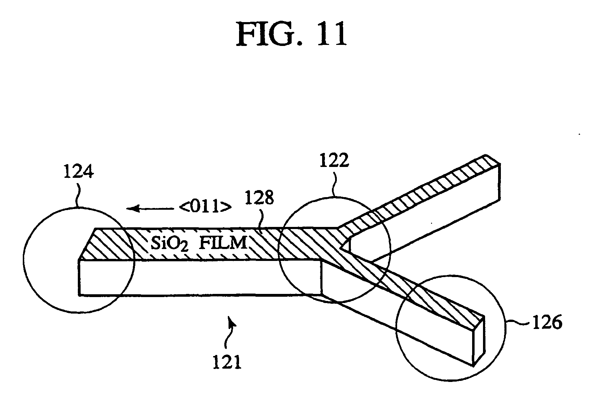

On the other hand, the wave guide of the optical integrated circuit has the function of coupling various devices and, for its functioning, has parts of different directions, a branch part and a terminal part. FIG. 11 is a view of a structure of the active layer mesa stripe of the optical integrated circuit with SiO₂ film as the selective growth mask. As shown in FIG. 11, a branch part 122 and a terminal part 124 are formed in the active layer mesa stripe 121 of the optical integrated circuit, and a part 126 in a direction other than <011> direction is formed in the active layer mesa stripe. In order to form the buried layer in such active layer mesa stripe 121, an SiO₂ film 128 is formed as a selective growth mask.

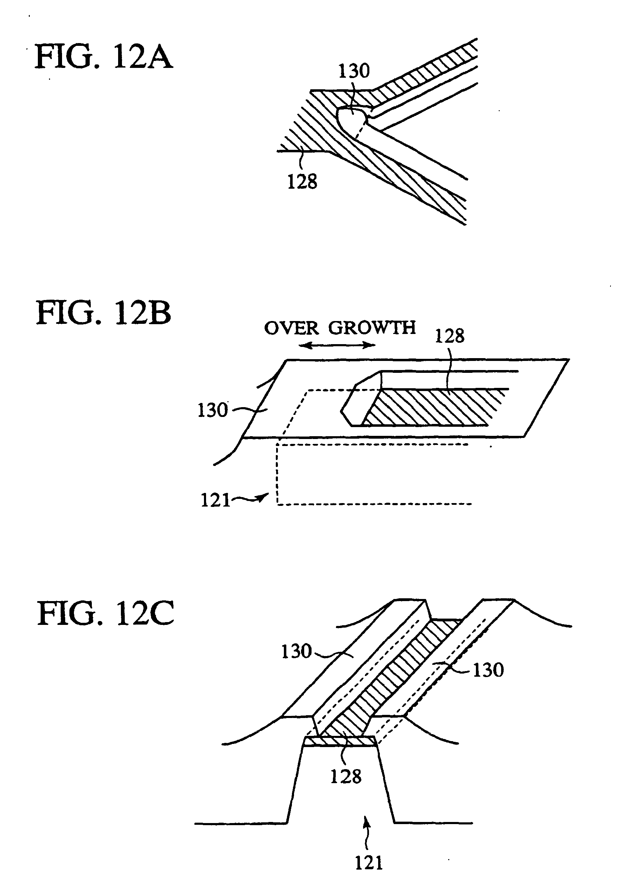

When the selective growth mask is formed at the branch part 122 or the terminal part 124, or part 126 is of a direction other than <011> direction, no specific growth stop plane is present in forming the buried layer. Accordingly, the buried layer grows over the selective growth mask. FIGs. 12 A, 12B and 12C respectively show growth of the buried layer at the branch part 122, the terminal part 124 and the part 126 of a direction other than <011> direction. As shown in FIGs. 12A-12C, at the branch part 122 and the other locations, the buried layer 120 is formed, growing over the SiO₂ film 128, this being the selective growth mask formed on the active layer mesa stripe 121. Such over growth of the buried layer 130 cannot be prevented even by addition of chlorine gas at the time of crystal growth.

In the optical integrated circuit, stacking dislocations undesirably occur in a part where the above-described over growth has taken place. Furthermore, the overhang of the buried layer formed by the overgrowth form voids therebelow in the layer 136 are formed in layers on both sides of the active layer mesa stripe 121 formed on an n type InP substrate 132. Furthermore, on the upper surface of these layers a p type InP clad layer 138, a p type InGaAs contact layer 140 are sequentially formed. The n type InP buried layer 136 has overhanging parts 142 growing over the active layer mesa stripe 121. Below the overhanging parts 142, the p type InP clad layer 138 is not formed, forming voids 144.

The stacking dislocation and void due to the above-described overgrowth of the buried layer causes deflection of a refractive index which hinders waveguide of light, and furthermore cause electric characteristic deterioration in the operation of the device. A related known method is described in US-A-5260230.

It is desirable to provide a method for fabricating a semiconductor device which can grow a buried layer on a projected structure, such as a mesa stripe, without overgrowth.

According to the present invention there is provided a method for fabricating an optical semiconductor device comprising the steps of: (a) providing a mesa stripe including a surface with a selective growth mask thereon, said selective growth mask not being formed at the peripheral part of the mesa stripe; (b) providing a first buried layer of a p-type InP or an Fe-doped p-type InP at the peripheral part of the mesa stripe, the surface of the said first buried layer being higher near an edge of the mesa stripe compared to the height of the first buried layer in a region further away from the edge; (c) forming a second buried layer of an n-type III - V group semiconductor with Se or S added in an above 5x 10¹⁸ cm⁻³ concentration by metal organic vapour phase epitaxy - MOVPE - in which a gas containing chlorine is added, on the said first buried layer, also at the peripheral part of the mesa stripe, the second buried layer not being formed on the surface of the mesa stripe that has the selective growth mask formed thereon, the mesa stripe having a branching part, wherein a surface of the second buried layer is higher than that of the mesa stripe at least near an edge of the selective growth mask; (d) forming a clad layer over the second buried layer; and (e) forming contact layers over the clad layer.

In the above-described method for fabricating semiconductor device it is possible that the III - V group semiconductor of the second buried layer is InP.

In the above-described method for fabricating semiconductor device it is possible that the mesa stripe has a terminal part.

In the above-described method for fabricating semiconductor device it is possible that the mesa stripe has a <011> direction part and a part of a direction other than the <011> direction.

In the above-described method for fabricating semiconductor device it is possible that the selective growth mask is a film of silicon oxide and/or silicon nitride.

For a better understanding of the invention and to show how the same can be carried into effect, reference will now be made to the accompanying drawings wherein:
FIG. 1A-1E are sectional views showing the stepwise manufacture of a first semiconductor based optical integrated circuit embodying this invention.
FIG. 2 is a graph of the relationships between overhanging lengths of a branched part, and Se concentrations.
FIG. 3 is a graph of growth substrate orientation dependence of Se doping efficiency.
FIG. 4 is diagrammatic view of the conventional way of suppressing growth of a semiconductor layer on a specific surface by adding Se.
FIGs. 5A-5E are sectional views showing the stepwise manufacture of a first semiconductor based optical integrated circuit embodying this invention.
FIGs. 6A-6C are perspective views of the second optical integrated circuit at stages in its manufacture.
FIGs. 7A-7E are sectional views showing the stepwise manufacture of a first semiconductor based optical integrated circuit embodying this invention.
FIGs. 8A-8C are perspective views of the third optical integrated circuit at stages in its manufacture.
FIG. 9 is a graph of substrate orientation dependence of S doping efficiency.
FIGs. 10A-10E are sectional views of a semiconductor laser having a BH structure at stages in its manufacture.
FIG. 11 is a diagrammatic view of the active layer mesa stripe of the optical integrated circuit, which has the selective growth mask formed on.
FIGs. 12A-12C are diagrammatic views of the over growth of the buried layer on the selective growth mask.

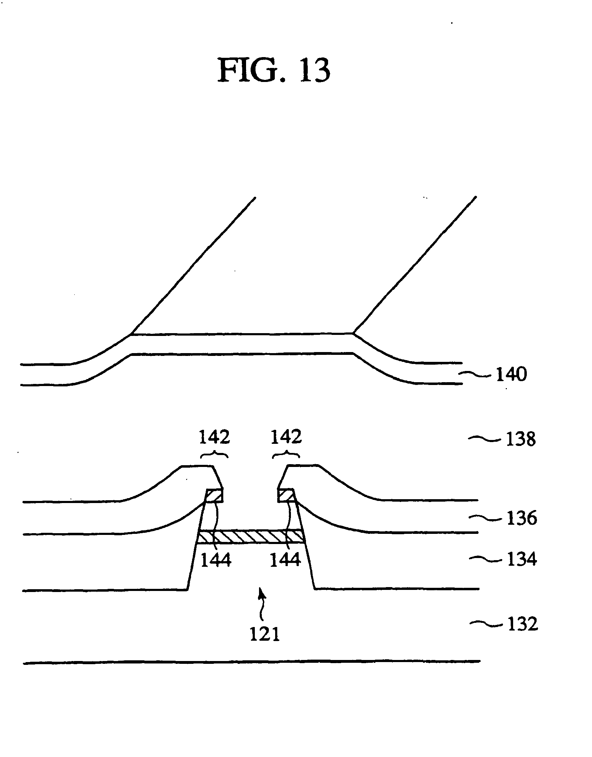

FIG. 13 is a diagrammatic sectional view of the optical integrated circuit having voids formed by the over growth of the buried layer.

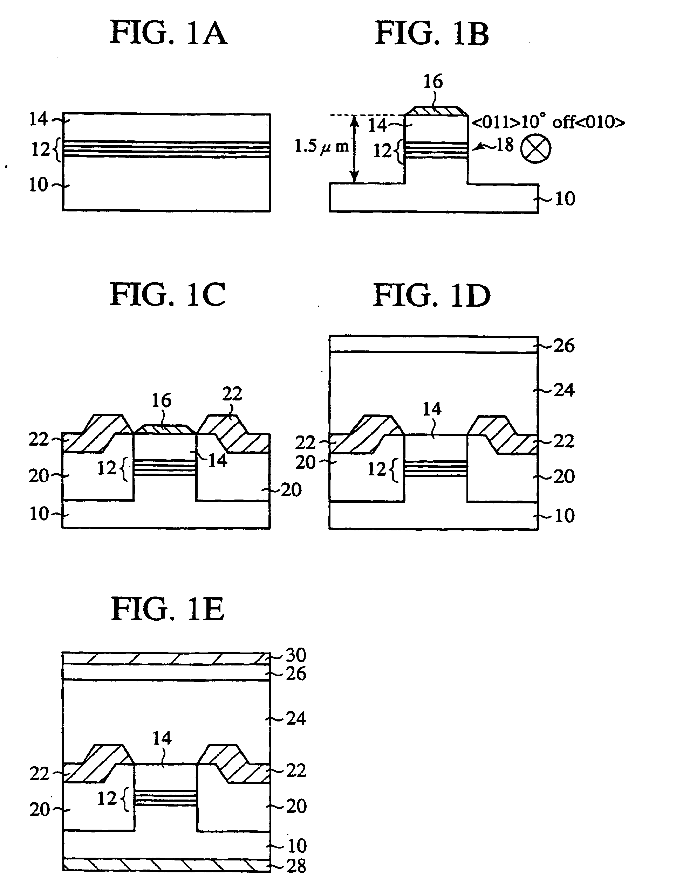

A method for fabricating a semiconductor device according to a first embodiment of the present invention, for use in an optical integrated circuit will be explained with reference to FIGs. 1A-1E, 2, 3, and 4.

The method for fabricating an optical integrated circuit is to form a BH structure in a mesa stripe in a direction other than <011> direction.

First, as shown in FIG. 1A, an InGaAsP/InGaAsP multi-quantum well layer 12 and a p type InP clad layer 14 are formed sequentially on an n type InP substrate 10.

Next, as shown in FIG. 1B, an SiO₂ film 16 as an etching protection film is formed on the p type InP clad layer 14, and an active layer mesa stripe 18 of approx height 1.5 µm having, e.g., <011> 10° off <010> direction, i.e., a direction tilted by 10° <010> direction off <011> direction is formed by dry etching.

Subsequently, as shown in FIG. 1C, an about 1 µm-layer thickness p type InP buried layer 20 is crystal-grown on the InP substrate 10 on both sides of the active layer mesa stripe 18 by MOVPE with the SiO₂ film 16 as a selective growth mask. TMI (TriMethyl Indium) and PH₃ are used as a group III element material and a group V element material respectively. As a dopant gas DEZn (DiEthylzinc) is used to add Zn to the p type InP buried layer 20, and a p dopant concentration becomes about 1x10¹⁸cm⁻³. The temperature and pressure for the growth are about 630 °C and about 0.1 atmospheric pressure respectively.

Following the formation of the p type InP buried layer 20, a buried layer 22 of approx thickness 0.7 µm is grown on the p type InP buried layer 20 by MOVPE (FIG. 1C). As a dopant gas, H₂Se is used to add Se to the InP buried layer 22, and the n dopant concentration amounts to about 5x10¹⁸ cm⁻³.

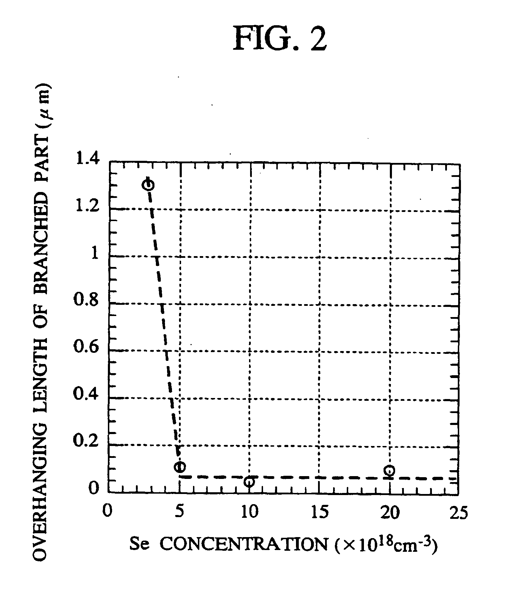

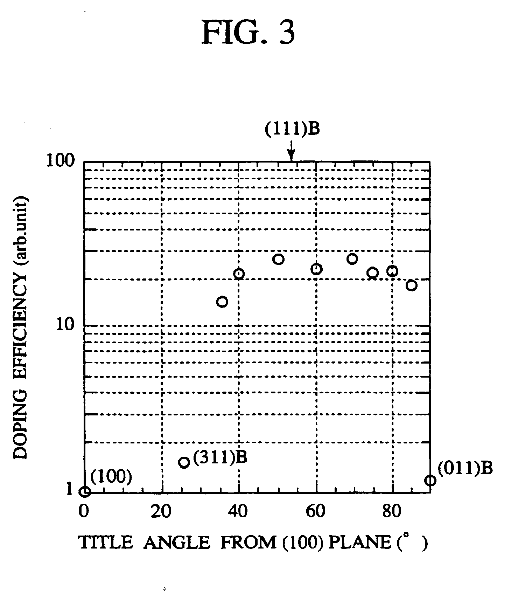

The effect of adding Se as an n type dopant in growing the n type InP buried layer 22 will be explained with reference to FIGs. 2 and 3.

FIG. 2 is a graph of Se concentration dependence of overhanging lengths of the n type InP buried layer over the selective growth mask at a branch part of the mesa stripe of 1.5 µm-height. As apparent in FIG. 2, the overgrowth is substantially completely stopped at an added Se concentration of above 5x10¹⁸ cm⁻³. This phenomenon is explained as follows.

Se, which is a VI group element, is taken in at P lattice as an electron donor when the n type InP grows. The Se has doping efficiency (n type donor concentration/ dopant dose) which varies depending on substrate location. FIG. 3 is a graph of the variation of the Se doping efficiency according to substrate location. As is apparent from FIG. 3, in comparison with the doping efficiency in planes from (100) plane to (211)B plane and in the (011)B plane, the doping efficiency in the other planes is increased by above 1 unit order.

It is known that grown planes, such as (111)B plane, etc., in the orientation where the Se doping efficiency is higher, are dominant at the margins of the selective growth mask. Accordingly, when Se is added in a 5x10¹⁸ cm⁻³ concentration in (100) plane, Se concentration in a plane at the margin of the selective growth mask is as high as 5x10¹⁹ cm⁻³, and the Se occupies the lattice points, as a result of which InP crystal growth will be stopped. Furthermore, the raw material gas is not consumed on the selective growth mask, and the raw material will be diffused from the selective growth mask to the epitaxial layer. As a result, Se concentration at the end of the selective growth mask will be increased more than estimated based on the substrate orientation dependence of the Se concentration.

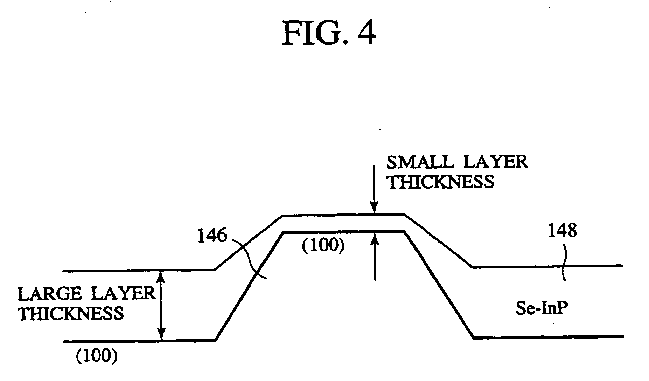

A technique of adding Se in a concentration of above 8x10¹⁸ cm⁻³ to an InP buried layer to thereby suppress the growth onto a specific plane is disclosed in Japanese Patent Application Laid-Open Publication No. JP-A-6283816. In this technique, as shown in FIG. 4, a buried structure is formed on a <011> mesa stripe 146 without use of a selective growth mask. At this time, the buried layer 148 is formed with Se added so as to take advantage of the fact that the growth rate on a (100) mesa top surface is lower than that at a (100) mesa side surface to thereby suppress the growth of the buried layer 148 on the (100) mesa top surface.

In contrast to this, in the present invention, there is suppression of overgrowth of the mesa stripe with the selective growth mask formed on. This technique is applicable to the active layer mesa stripe of directions other than <011>. Furthermore, the present invention is based on the principle that the growth rate becomes lower in a location where Se doping efficiency increases. Thus, the invention disclosed in Japanese Patent Application Laid-Open Publication No. JP-A-6283816 is apparently different form the present invention.

As described above, the method according to the present invention, for fabricating an optical integrated circuit is characterized in that Se is added as an n type dopant in forming the n type InP buried layer on the mesa stripe with the selective growth mask formed on. The method for fabricating an optical integrated circuit according to the present embodiment, can suppress overgrowth of the n type InP buried layer on the selective growth mask.

As described above, the SiO₂ film 16 is removed by etching using HF after the n type InP buried layer 22 is formed without overgrowth. Subsequently, as shown in FIG. 1D, a p type InP clad layer 24 and a p type InGaAs contact layer 26 are sequentially formed.

Finally, as shown in FIG. 1E, an n type electrode 28 is formed on the underside of the n type InP substrate 10, and a p type electrode 30 is formed on the p type InGaAs contact layer 26. Thus, the fabrication of an optical integrated circuit is completed.

As described above, according to the present embodiment, Se is added as an n type dopant to form the n type InP buried layer, whereby the n type InP buried layer can be grown without overgrowth on the selective growth mask.

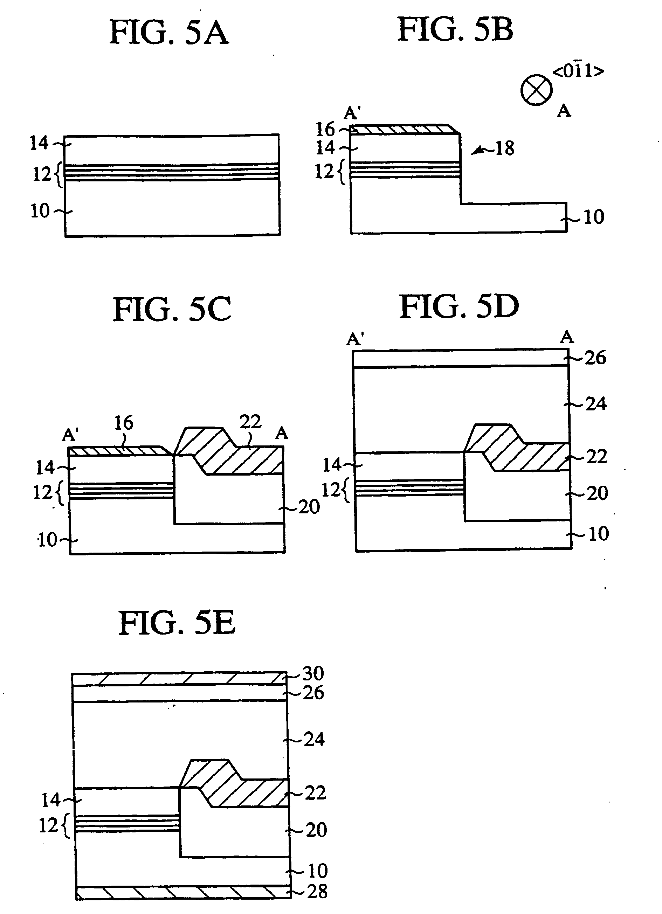

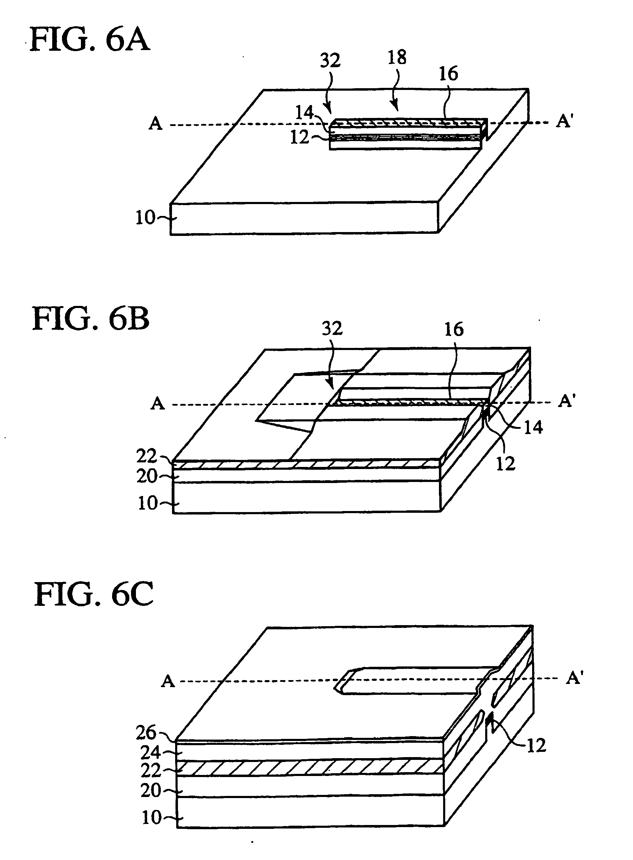

A method for fabricating a semiconductor device according to a second embodiment of the present invention, for use in an optical integrated circuit will be explained with reference to FIGs. 5A-5E and 6A-6C. FIG. 5A-5E are sectional views of an optical semiconductor device of the present embodiment showing the steps for fabricating a semiconductor device. FIGs. 6A-6C are perspective views of the optical integrated circuit of the present embodiment, which show the method for fabricating semiconductor device for use in the optical integrated circuit.

The method of fabricating a semi-conductor device, according to the present embodiment, for use in an optical integrated circuit includes forming a BH structure having a mesa stripe with a terminal part.

First, as shown in FIG. 5A, an InGaAsP/InGaAsP multi-quantum well layer 12 and a p type InP clad layer 14 are sequentially formed on an n type InP substrate 10.

Next, as shown in FIGs. 5B and 6A, an SiO₂ film 16 is formed as an etching protection film on the p type InP clad layer 14 and an active layer mesa stripe 18 of approximate height 1.5 µm is formed by dry etching. The active layer has <011> direction. The active layer mesa stripe 18 has a terminal part 32. FIG. 5B is a sectional view along the line A-A' in FIG. 6A.

Next, as shown in FIGs. 5C and 6B, with the SiO₂ film 16 as a selective growth mask, a p type InP buried layer 20 of approx. 1 µm thickness is grown by MOVPE on the InP substrate 10 on both sides of the active layer mesa stripe 18. FIG. 5C is a sectional view along the line A-A' in FIG. 6C. TMI and PH₃ are used as group III element materials and a group V element material respectively. DEZn is used as a dopant gas to add Zn to the p type InP buried layer at a p doping concentration of about 1x10¹⁸ cm⁻³. The temperature and pressure for the growth are about 630 °C and about 0.1 atmospheric pressure respectively.

Following the formation of the p type InP buried layer 20, an n type InP buried layer 22 of approx. thickness of 0.7 µm is grown by MOVPE on: the p type InP buried layer 20 (FIGs. 5C and 6b). H₂Se is used as a dopant gas to add Se to the n type InP buried layer 22, at an n doping concentration of about 5x10¹⁸ cm⁻³.

As in the first embodiment, Se is added in growing the n type InP buried layer 22, whereby the overgrowth of the n type InP buried layer 22 is prevented at terminal part 32.

The SiO₂ film 16 is removed by etching using HF, and, as shown in FIGs. 5D and 6C, a p type InP clad layer 24 and a p type InGaAs contact layer 26 are sequentially formed on the entire surface. FIG. 5D is a sectional view along the line A-A' in FIG. 6C.

Finally, as shown in FIG. 5E, an n type electrode 28 is formed on the underside of the n type InP substrate 10, and a p type electrode 30 is formed on the p type InGaAs contact layer 26. Thus, the fabrication of an optical integrated circuit is completed.

As described above, according to the present embodiment, Se is added as an n type dopant to form the n type InP buried layer, whereby the n type InP buried layer can be grown without overgrowth on the selective growth mask.

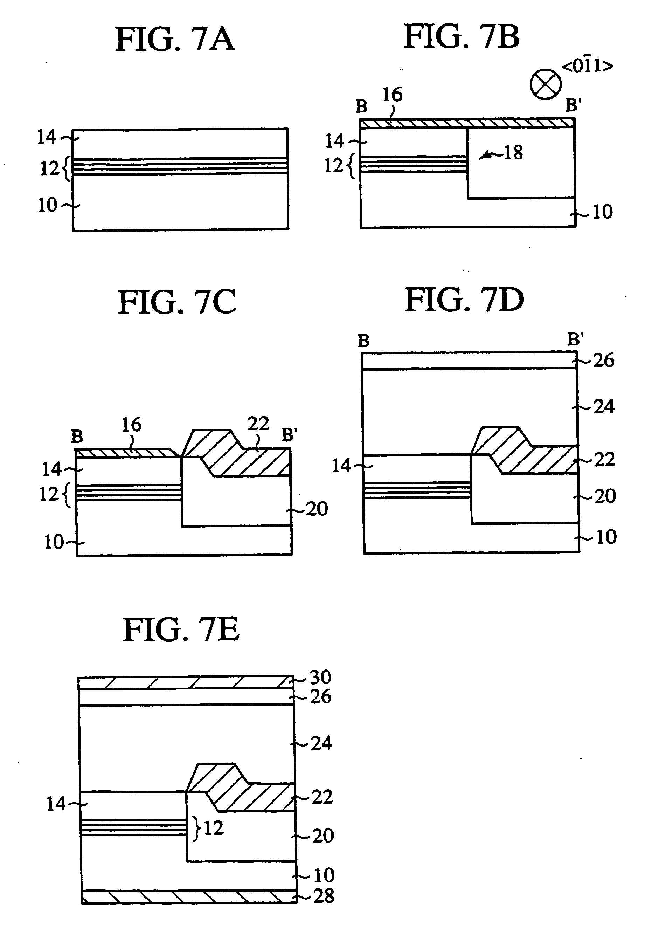

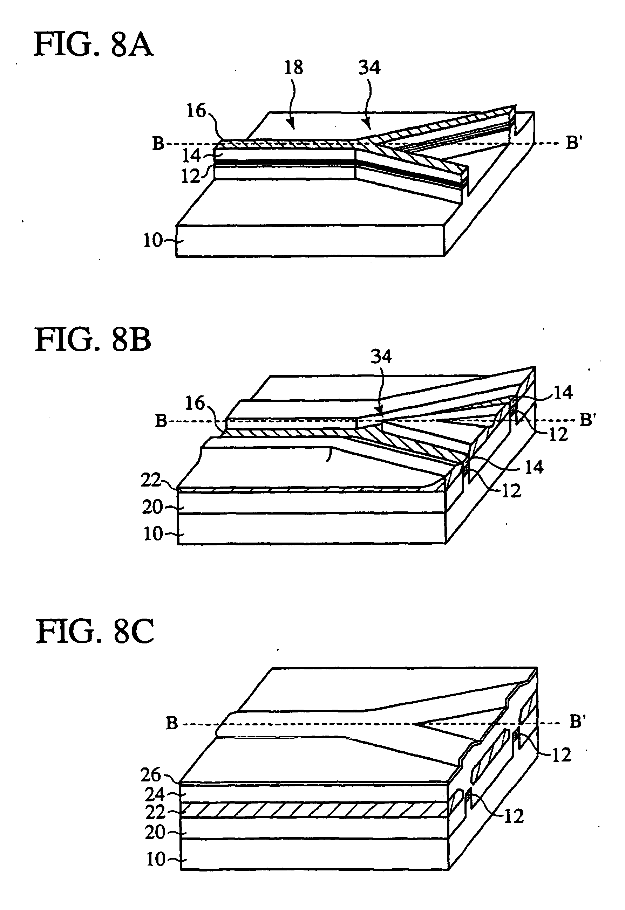

A method for fabricating a semiconductor device according to a third embodiment of the present invention for use in an optical integrated circuit will be explained with reference to FIGs. 7A-7E and 8A-8C. FIGs.7A-7E are sectional views of the optical integrated circuit of the present embodiment showing the steps for fabricating a semiconductor device. FIGs. 8A-8C are perspective views of the method for fabricating a semiconductor device for use in an optical integrated circuit.

The method of fabricating a semiconductor device according to the present embodiment for use in an optical integrated circuit, includes forming a BH structure having a mesa stripe with a branching part.

As shown in FIG. 7A, an InGaAsP/InGaAsP multi-quantum well layer 12 and a p type InP clad layer 14 are sequentially formed on an n type InP substrate 10.

Then, as shown in FIGs. 7B and 8A, an SiO₂ film 16 is formed as an etching protection film on a p type InP clad layer 14, and an active layer mesa stripe 18 of approx. height 1.5 µm is formed by dry etching. The active layer mesa stripe 18 has a branching part 34. FIG. 7B is a sectional view along the line B-B' in FIG. 8A.

Subsequently, as shown in FIG. 7C and 8B, with the SiO₂ film 16 as a selective growth mask, a buried layer 20 of approx. 1µm thickness is grown by MOVPE on the InP substrate 10 on both sides of the active layer mesa stripe 18. FIG. 7C is a sectional view along the line B-B' in FIG. 8B. TMI and PH₃ are used as a group III element material and a group V element material respectively. DEZn is used as a dopant gas to add Zn to the p type InP buried layer 20, at a p doping concentration of about 1x10¹⁸ cm⁻³. A temperature and pressure for the growth are about 630 C and about 0.1 atmospheric pressure respectively.

Following the formation of the p type InP buried layer 20, an n type InP buried layer 22 of approx. 0.7 µm thickness is grown (FIGs. 7C and 8B). H₂Se is used as a dopant gas to add Se to the n type InP buried layer 22, at an n doping concentration of about 5x10¹⁸ cm⁻³.

As in the first embodiment, Se is added for growth of the n type InP buried layer 22, whereby the overgrowth of the n type InP buried layer 22 is prevented at the branching part 34.

The SiO₂ film 16 is removed by etching using HF, and as shown in FIGs. 7D and 8C, a p type InP clad layer 24 and a p type InGaAs contact layer 26 are sequentially formed on the entire surface. FIG. 7D is a sectional view along the line B-B' in FIG. 8C.

Finally, as shown in FIG. 7E, an n type electrode 28 is formed on the underside of the n type InP substrate 10, and a p type electrode 30 is formed on the p type InGaAs contact layer 26. Thus, the fabrication of an optical integrated circuit is completed.

As described above, according to the present embodiment, in forming the n type InP buried layer, Se is added as an n type dopant, whereby the n type InP buried layer can be formed without overgrowth on the selective growth mask.

At the time of growing the n type and the p type InP buried layer by MOVPE in the above-described embodiments, a gas containing chlorine, such as Cl₂, HCl, CH₃Cl, CCl₄, CH₃CH₂Cl, PCl₃ or others, is added.

The present invention is not limited to the above-described embodiments and can cover other various modifications.

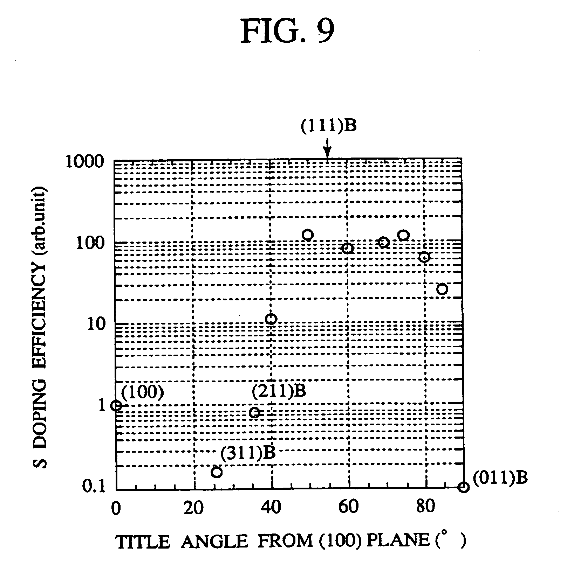

For example, in the above-described embodiments, in forming the n type InP buried layer 22, H₂Se is used as an n type dopant to add Se. However, this invention is not limited to Se. Other group VI element besides Se can be incorporated in P lattice points to be donors. For example, as shown in FIG. 9, substrate location dependent doping efficiency with S is increased by more than 2 units near the (111)B plane as against the (100) plane. Accordingly, H₂S is usable as an n type dopant for growing the n-InP buried layer.

In the above-described embodiments, in forming the p type InP buried layer 20, DEZn is used as a dopant gas to add Zn, but the dopant gas is not limited to DEZn. For example, Cp₂Fe may be used as a dopant to add Fe.

In the above-described embodiments, the SiO₂ film 16 is formed as an etching mask for forming the active layer mesa stripe 18, but the etching mask is not limited to SiO₂ film. In place of SiO₂ film, Si₃N₄ film, SiON film or others may be used.

In the above-described embodiments, InP is used as a material of the buried layer, but the material of the buried layer is not limited to InP. Other group III and group V semiconductors besides InP may be used as a material of the buried layer.

In the above-described embodiments, the InGaAsP/InGaAsP multi-quantum well layer 12 is used as the active layer, but the structure of the active layer is not limited to this quantum well structure.

As described above, according to the present invention, a buried layer of a group III-V semiconductor treated with Se or S added at a concentration above 5x10¹⁸ cm⁻³, in which a gas containing chlorine is added, during formation of the buried layer will prevent overgrowth at the periphery of a projected structure in the presence of a growth mask, the projected structure itself.

## Claims

1. A method for fabricating an optical semiconductor device comprising the steps of:
(a) providing a mesa stripe (18) including a surface with a selective growth mask (16) thereon, said selective growth mask not being formed at the peripheral part of the mesa stripe (18);
(b) providing a first buried layer (20) of a p-type InP or an Fe-doped p-type InP at the peripheral part of the mesa stripe (18), the surface of the said first buried layer (20) being higher near an edge of the mesa stripe (18) compared to the height of the first buried layer (20) in a region further away from the edge;
(c) forming a second buried layer (22) of an n-type III - V group semiconductor with Se or S added in an above 5x 10¹⁸ cm⁻³ concentration by metal organic vapour phase epitaxy - MOVPE - in which a gas containing chlorine is added, on the said first buried layer (20), also at the peripheral part of the mesa stripe (18), the second buried layer (22) not being formed on the surface of the mesa stripe (18) that has the selective growth mask (16) formed thereon, the mesa stripe (18) having a branching part (34), wherein a surface of the second buried layer (22) is higher than that of the mesa stripe (18) at least near an edge of the selective growth mask (16);
(d) forming a clad layer (24) over the second buried layer (22); and
(e) forming contact layers (26) over the clad layer (24).

2. A method according to claim 1, wherein the III - V group semiconductor of the second buried layer is InP.

3. A method according to any preceding claim, wherein the mesa stripe (18) has a terminal part.

4. A method for fabricating a semiconductor device according to any preceding claim, wherein the mesa stripe (18) has a <011> direction part and a part having a direction other than the <011> direction.

5. A method according to any preceding claim, wherein the selective growth mask (16) is a film of silicon oxide and/or silicon nitride.

## Patentansprüche

1. Verfahren zum Herstellen einer optischen Halbleitervorrichtung mit den Schritten:
(a) Vorsehen eines Mesa-Streifens (18), der eine Oberfläche mit einer darauf angeordneten selektiven Wachstumsmaske (16) enthält, welche selektive Wachstumsmaske nicht an dem peripheren Teil des Mesa-Streifens (18) gebildet ist;
(b) Vorsehen einer ersten vergrabenen Schicht (20) aus p-Typ-InP oder mit Fe-dotiertem p-Typ-InP an dem peripheren Teil des Mesa-Streifens (18), wobei die Oberfläche der ersten vergrabenen Schicht (20) nahe einem Rand des Mesa-Streifens (18) im Vergleich zu der Höhe der ersten vergrabenen Schicht (20) in einer Region, die von dem Rand weiter entfernt ist, höher ist;
(c) Bilden einer zweiten vergrabenen Schicht (22) aus einem n-Typ-Halbleiter der Gruppe III-V, dem Se oder S in einer Konzentration von über 5x10¹⁸ cm⁻³ beigemengt sind, durch metallorganische Dampfphasenepitaxie - MOVPE - unter Zusatz eines chlorhaltigen Gases auf der ersten vergrabenen Schicht (20), auch an dem peripheren Teil des Mesa-Streifens (18), wobei die zweite vergrabene Schicht (22) nicht auf der Oberfläche des Mesa-Streifens (18) gebildet wird, auf der die selektive Wachstumsmaske (16) gebildet ist, welcher Mesa-Streifen (18) einen Verzweigungsteil (34) hat, bei dem eine Oberfläche der zweiten vergrabenen Schicht (22) wenigstens nahe einem Rand der selektiven Wachstumsmaske (16) höher als die des Mesa-Streifens (18) ist;
(d) Bilden einer Mantelschicht (24) über der zweiten vergrabenen Schicht (22); und
(e) Bilden von Kontaktschichten (26) über der Mantelschicht (24).

2. Verfahren nach Anspruch 1, bei dem der Halbleiter der Gruppe III-V der zweiten vergrabenen Schicht InP ist.

3. Verfahren nach einem vorhergehenden Anspruch, bei dem der Mesa-Streifen (18) einen Anschlussteil hat.

4. Verfahren zum Herstellen einer Halbleitervorrichtung nach einem vorhergehenden Anspruch, bei dem der Mesa-Streifen (18) einen <011>-Richtungsteil hat, sowie einen Teil mit einer Richtung, die eine andere als die <011>-Richtung ist.

5. Verfahren nach einem vorhergehenden Anspruch, bei dem die selektive Wachstumsmaske (16) ein Film aus Siliziumoxid und/oder Siliziumnitrid ist.

## Revendications

1. Procédé de fabrication d'un dispositif à semi-conducteurs optique comprenant les étapes consistant à :
(a) fournir une bande mésa (18) comprenant une surface avec un masque de croissance sélectif (16) sur celle-ci, ledit masque de croissance sélectif n'étant pas formé dans la partie périphérique de la bande mésa (18) ;
(b) fournir une première couche enterrée (20) d'InP de type p ou d'InP de type p dopé au Fe dans la partie périphérique de la bande mésa (18), la surface de ladite première couche enterrée (20) étant plus élevée à proximité d'un bord de la bande mésa (18) comparé à la hauteur de la première couche enterrée (20) dans une région plus éloignée du bord ;
(c) former une deuxième couche enterrée (22) d'un semi-conducteur des groupes III-V de type n avec du Se ou du S ajouté en une concentration supérieure à 5 x 10¹⁸ cm⁻³ par épitaxie en phase vapeur organométallique, MOVPE, dans laquelle un gaz contenant du chlore est ajouté, sur ladite première couche enterrée (20), également dans la partie périphérique de la bande mésa (18), la deuxième couche enterrée (22) n'étant pas formée sur la surface de la bande mésa (18) sur laquelle le masque de croissance sélectif (16) est formé, la bande mésa (18) comportant une partie de branchement (34), dans lequel une surface de la deuxième couche enterrée (22) est plus élevée que celle de la bande mésa (18) au moins à proximité d'un bord du masque de croissance sélectif (16) ;
(d) former une couche de gainage (24) sur la deuxième couche enterrée (22) ; et
(e) former des couches de contact (26) sur la couche de gainage (24).

2. Procédé selon la revendication 1, dans lequel le semi-conducteur des groupes III-V de la deuxième couche enterrée est de l'InP.

3. Procédé selon l'une quelconque des revendications précédentes, dans lequel la bande mésa (18) comporte une partie de borne.

4. Procédé de fabrication d'un dispositif à semi-conducteurs selon l'une quelconque des revendications précédentes, dans lequel la bande mésa (18) a une partie de direction <011> et une partie ayant une direction autre que la direction <011>.

5. Procédé selon l'une quelconque des revendications précédentes, dans lequel le masque de croissance sélectif (16) est une couche d'oxyde de silicium et/ou de nitrure de silicium.
